# EUROPEAN PATENT SPECIFICATION

(11) **EP 0 305 691 B1**
(45) Date of publication and mention of the grant of the patent: **07.04.1993**
(21) Application number: 88111164.5
(22) Date of filing: 12.07.1988
(51) Int. Cl.: H01L 21/90, H01L 21/306

(54) **Method of forming a plurality of conductive studs within an insulator layer**
Verfahren zur Ausbildung einer Vielzahl leitender Zapfen in einer Isolierschicht
Méthode pour former une pluralité de piliers conducteurs dans une couche isolante

(30) Priority: 17.08.1987 US 85836
(43) Date of publication of application: 08.03.1989
(73) Proprietor: International Business Machines Corporation, Armonk, N.Y. 10504 (US)
(72) Inventor: Cote, William J., Essex Junction Vermont 05452 (US); Kaanta, Carter W. Grandview Road, Vermont 05446 (US); Leach, Michael A., Winooski Vermont 05404 (US); Paulsen, James K. Steam Mill Road, Vermont 05465 (US)
(74) Representative: Mönig, Anton, Dipl.-Ing.

(56) References cited:
- EP-A- 0 177 105
- EP-A- 0 223 920
- EP-A- 0 224 013
- PATENT ABSTRACTS OF JAPAN, vol. 9, no. 19 (E-292)[1742], 25th January 1985 & JP-A-59 165 427 (NIPPON DENKI K.K.) 18-09-1984

## Description

The invention is directed to a method of forming a plurality of conductive studs within an insulator layer and especially to simultaneously planarizing metal and insulator films so as to form planarized, filled vias.

As the device densities of integrated circuits continue to increase, the metallurgy technologies utilized to interconnect individual devices must meet more stringent requirements. For one, higher device counts necessitate multiple levels of metallurgy. As the number of metal layers increases, it is important that the insulator layers separating these metal layers be as planar as possible. If planarity is not maintained, the resulting severe topologies may cause metal opens or shorts.

Another constraint placed upon state-of-the-art metallurgy technologies is that the vias utilized to interconnect the metal layers must be formed in as small a space as possible. This is commonly accomplished by anisotropically patterning the insulator (e.g., by reactive ion etching (RIE) in a fluorine-based gaseous plasma) to form vias having vertical sidewalls.

Yet another constraint is the minimization of contact resistance. Because of the sheer number of devices to be connected at the first level of metal, the resistive load on (and hence the signal delays associated with) this metal level will increase. Interconnect materials that minimize contact resistance will decrease loading. Refractory metals such as tungsten have been shown to possess the requisite resistivity properties. Moreover, because CVD tungsten can be conformally deposited to fill vertical-walled vias formed in an insulator layer, the previously-mentioned via density constraint can also be met by the adoption of CVD tungsten as the interconnect material.

Prior art approaches have attempted to provide a planarized insulating layer having planarized studs imbedded therein. U.S. Patent 4,470,874, entitled "Planarization of Multi-Level Interconnected Metallization System" (issued September 11, 1984, to Bartush et al and assigned to the assignee of the present invention) discloses a process wherein aluminum-based studs are formed on a substrate, a glass passivation layer is deposited to cover the stud, a planarizing photoresist layer is deposited on the passivation layer, the photoresist layer is exposed to an etchant that removes the photoresist layer and the glass passivation layer at substantially the same rate, and residual amounts of the glass passivation layer are removed in an etchant that attacks the previously-formed interconnect studs and the glass passivation layer at substantially the same rate. Note that this latter etchant, is disclosed as being an argon-based sputter etch, an ion milling step or a polishing step.

U.S. Patent 4,614,021, entitled "Pillar Via Process" (issued September 30, 1986, to Hulseweh et al and assigned to Motorola) discloses a process wherein a first level of metal is defined on a substrate, interconnecting stud structures are defined on the first metal layer, a thick passivation layer is deposited to cover the conductive studs, a planarizing resist layer is coated on the dielectric layer, and the resist layer is exposed to an etchant that removes the resist and the passivation layer at substantially the same rate so as to planarize the passivation layer.

In the prior art it is also known to coat a dielectric layer on a substrate, define vias in the dielectric layer, fill the vias with metal, coat the structure with a planarizing resin layer, and expose the resin layer to an etchant that removes the resin as well as portions of the metal layer outside the vias at substantially the same rate. Such processes are disclosed in U.S. Patent 4,520,041, entitled "Method for Forming Metallization Structure Having Flat Surface on Semiconductor Substrate" (issued May 28, 1985, to Aoyama et al and assigned to Toshiba) and U.S. Patent 4,614,563, entitled "Process for Producing Multi-Layer Conductor Structure" (issued September 30, 1986, to Kubo and assigned to Fuji Photo Film Company). In both processes, a metal:resin etch rate ratio of 1:1 must be maintained in order to provide a planar surface. Moreover, note that in both patents the portions of the metal laying outside the vias are disposed on a relatively planar passivation layer.

As shown in Fig. 3 of EP-A-0 223 920, which corresponds to U.S. Patent Application S.N. 791,860, another planarization method consists of planarizing the passivation layer prior to via definition, and then overfilling the subsequently-formed vias with metal. Portions of the metal lying outside the vias are then removed by polishing. More specifically, the application discloses (at Table 1) a plurality of acidic chem-mech slurrys that maximize the polishing rate of aluminum relative to silicon oxide.

EP-A-177105 describes a method for providing a semiconductor device with planarized contacts in which planarized insulating layers provided with planarized contacts are formed on semiconductor devices by forming vias through an insulating layer having a generally planar exposed surface, depositing a layer of a conductive layer on this upper surface of the insulating layer in an amount at least sufficient to at least partially fill all of the vias, depositing a planarized layer on the exposed surface of the conductive layer and then etching away the planarized layer and the conductive layer by use of an etchant that removes the planarized layer and the conductive layer at substantially the same rate, until the generally planar upper surface of the insulating layer is exposed.

In EP-A-224013 a method for producing coplanar multilevel metal/insulator films on a substrate is disclosed which comprises the following steps: providing a substrate having an underlying metallization therein; placing an insulator on said substrate; selectively removing first portions of said insulator at first locations, said first portions partially penetrating through said insulator; selectively removing second portions of said insulator at second locations, said second portions penetrating fully through the remainder of said insulator; said second portions being in alignment with some of said first portions; simultaneously depositing metal over said insulator to form an overlying metallization in said first locations and stud via connections in said second locations, and removing any of said metal which overlies said insulator at locations other than said first locations.

The present inventors investigated the possibility of planarizing the passivation film after via definition and prior to metal deposition.

If vias are defined in a pre-planarized passivation layer, the underlying topography will produce vias of grossly varying depths. If the etch process is continued so as to fully define the deepest vias, the more shallow vias will be greatly overetched and the underlying structures may be substantially eroded. At the same time, because of the above-mentioned vertical via and contact resistance constraints, the inventors wanted to utilize a conformal metal as the via-filling metallurgy. However, none of the above-mentioned prior art techniques specifically address simultaneously planarizing a via-filling metal and a non-planar insulator layer so as to form a planarized metal-insulator surface.

The invention as claimed in claim 1 or 10 is intended to remedy this drawback. It solves the problem of providing a planarized metal-insulator surface and of planarizing the passivation film after via definition without the use of a separate planarization layer.

The advantages of the present invention are realized by a method of forming a plurality of conductive studs within a non-planar insulator layer which follows the topology produced by the underlying layers, disposed between a first series of conductive structures arranged on a substrate and a second series of conductive structures formed on the insulator layer. Vias are defined through the insulator layer so as to expose one or more of the plurality of first conductive structures. A conformal conductive layer is deposited on the insulator layer so as to overfill the vias formed in said insulator layer. Then, both of the conductive layer and the insulator layer are planarized to remove portions of the conductive layer outside the vias while simultaneously planarizing the insulator layer by a polishing etch in the presence of an abrasive slurry.

The invention is described in detail below with reference to the drawings, in which:
- Figs. 1-4: are cross-sectional views of a semiconductor substrate undergoing the process steps in accordance with the method of the present invention;
- Fig. 5: is an SEM of a semiconductor substrate showing the results of the polish step of the present invention;
- Fig. 6: is an SEM of a section of the substrate shown in Fig. 5; and
- Fig. 7: is a cross-sectional view of a semiconductor substrate undergoing a process in accordance with a second embodiment of the present invention.

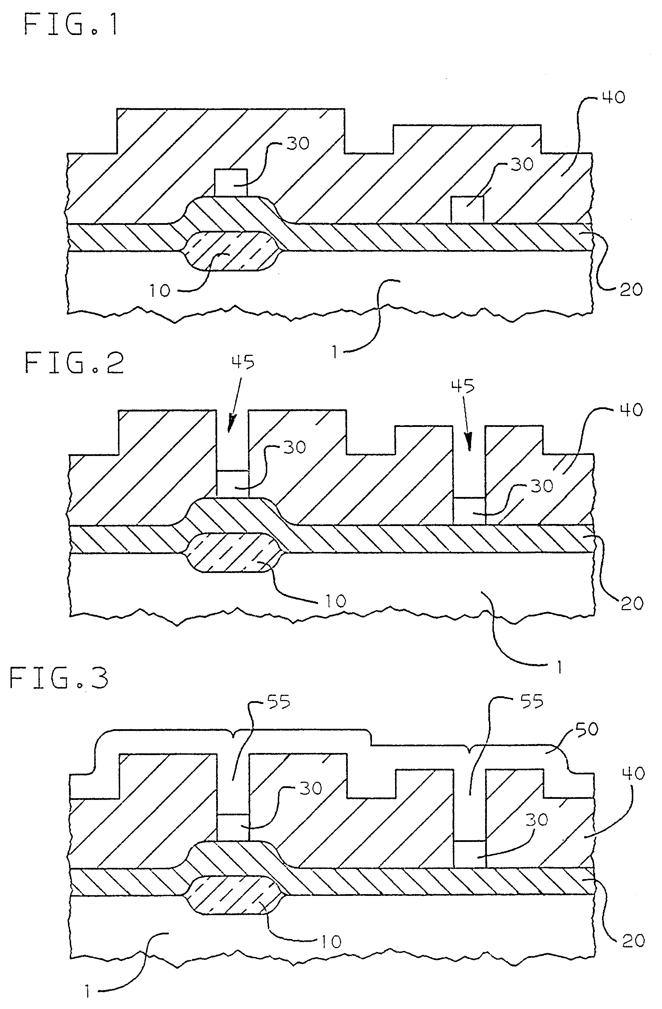

With reference to Fig. 1, the process of the present invention is carried out on a semiconductor substrate 1. For example, substrate 1 is made of p-type, <100> oriented monocrystalline silicon. The substrate is shown as being devoid of integrated circuit structures except for the semi-recessed oxide isolation region 10.

In practice, a plurality of diffusion regions are formed within the upper surface of the substrate, and a plurality of conductive structures (e.g., polycrystalline silicon gate electrodes, storage node electrodes, etc.) are provided on the surface of the substrate 1 to form integrated circuit devices. Such devices are not shown in Figs. 1-4 for ease of illustration. The semi-recessed oxidation structure 10 can be formed using conventional techniques, such as growing a thin layer of silicon oxide on the substrate, depositing a layer of silicon nitride on the silicon oxide layer, patterning the nitride-oxide layers to expose a region of the substrate, and oxidizing the exposed substrate regions.

After the integrated circuit structures (e.g., isolation structure 10) are formed on the substrate, a first passivation layer 20 is deposited. The passivation layer 20 can be any one of a number of known insulating materials, such as polyimide phosphosilicate glass (PSG), or boro-phosphosilicate glass (BPSG). A layer of metal is then deposited on the first passivation layer 20, and is patterned to form metal lines 30. While the metal layer can be any conductive material, it is preferred to form the metal lines 30 from an aluminum-based alloy such as Al/2%Cu or Al/4%Si/2%Cu. The metal lines 30 can be defined by anisotropically etching portions of the metal layer exposed by a photoresist in a chlorine-based gaseous plasma.

After the metal lines 30 have been defined, a second passivation layer 40 is deposited on the substrate. It is preferred to form the second passivation layer 40 from a doped glass (preferably BPSG). Note that the second passivation layer 40 has an uneven upper surface as deposited. That is, because doped glass passivation layers tend to be conformal, the upper surface thereof follows the contours produced by the underlying structures formed on the substrate.

As shown in Fig. 2, vias 45 are then formed in the second passivation layer 40 so as to expose the underlying metal lines 30. Vias 45 can be formed by depositing and patterning a conventional photoresist material, and anisotropically etching the exposed portions of the second passivation layer 40 in a halogen-based gaseous plasma such as CF₄. Because the upper surface of the second passivation layer 40 follows the topology produced by the underlying layers, the vias will be of equal depth. It will take the same amount of etching to completely define all of the vias 45 above the metal lines 30. The above process thus avoids the deleterious effects produced by overetching shallow vias during the definition of deeper vias as was done in prior art processes in which the passivation layer was planarized prior to via definition.

Then, as shown in Fig. 3, a second metal layer 50 is deposited on the patterned passivation layer 40. It is preferred to form the second metal layer 50 of a material that can be conformally deposited to fill the vias in the second passivation layer 40 without creating voids. It has been found that chemical vapor deposited (CVD) tungsten provides these properties. Note that because the second metal layer 50 is conformal, its upper surface follows the topology produced by the underlying structures. The second metal layer 50 should be at least thick enough (i.e., at least one-half the width of the vias in the cross-sectional dimension shown) to completely fill the vias 45 formed in the second passivation layer 40. The portions 55 of second metal layer 50 lying within the vias thus provide an electrical connection to metal lines 30.

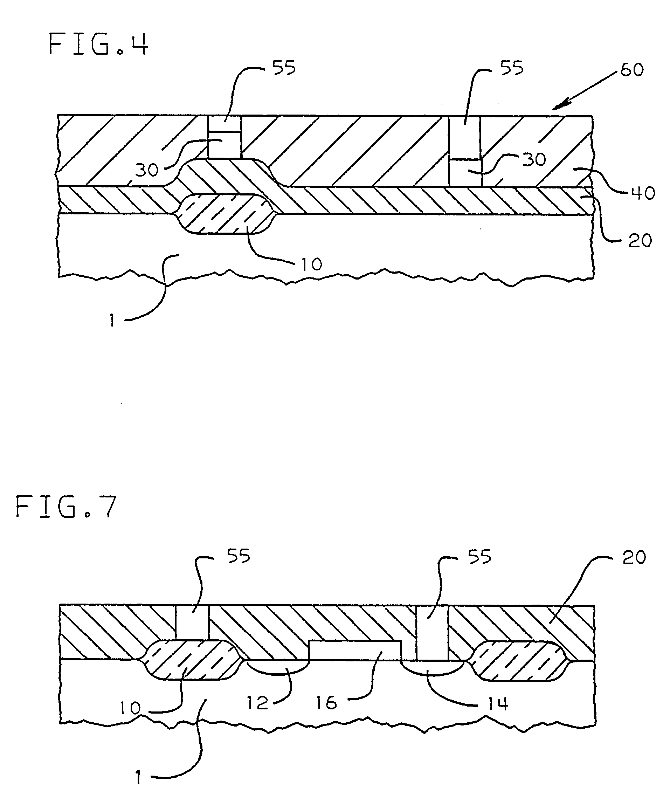

Then, as shown in Fig. 4, the metal layer 50 and passivation layer 40 are exposed to a planarization etch that removes portions of the metal layer 50 lying outside the vias while simultaneously planarizing the passivation layer. Thus, the resulting structure provides a planarized surface 60 upon which subsequent metal and insulator layers can be deposited.

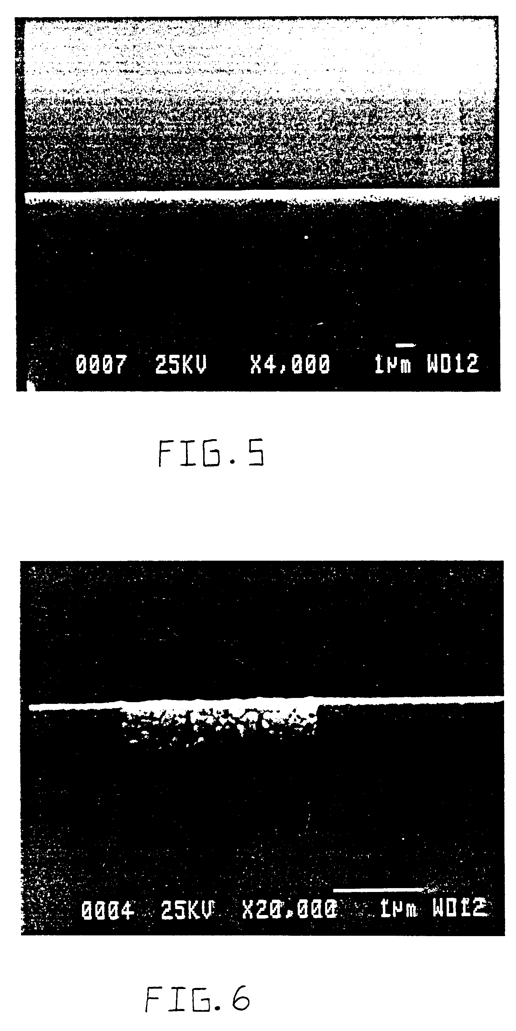

In the invention, this planarization etch is practiced by polishing the layers in the presence of an abrasive slurry. Experiments were carried out on a Strasbaugh single wafer polish tool. An abrasive SUBA IV perforated polishing pad was used. The pad was held at a pressure of approximately 68 - 87 KPa (0,86-0,87 bar). It was found that an abrasive slurry consisting of Al₂O₃ particulates, deionized water, a base, and an oxidizing agent will provide W:BPSG etch rates sufficient to produce a planar surface. Forty grams of Al₂O₃ particulates were mixed with ten liters of deionized water and approximately one liter of hydrogen peroxide (an oxidizing agent). In one experiment nitric acid was added to produce a slurry having a pH of 6. In another experiment, no acid/base was added. In a third experiment, potassium hydroxide was added to produce a slurry having a pH of about 8.4. At a pH of 6 or 7, no tungsten was removed. At a pH of 8.4, approximately 30 nm/minute of tungsten and 20 nm/minute of BPSG were polished away. The results of this pro-cess are illustrated by a scanning electron microscope (SEM) photograph of an experimental structure as shown in Fig. 5. The experimental structure was prepared by depositing a thick BPSG layer on a wafer, etching apertures into the thick layer of BPSG, coating CVD tungsten on the BPSG, and carrying out the above-described polishing process. The small boxes are the tungsten-filled apertures in BPSG. Note the total planarity of the upper surface. Fig. 6 shows a section of the substrate shown in Fig. 5 at a magnification of 5X. Note that the polishing process does not produce any delamination of the tungsten grains from the BPSG apertures. Further experiments in which the pH of the slurry was raised to 11 and above produced substantially the same results. That is, the polishing process produces a planar BPSG/W surface at higher W:BPSG etch rate ratios (e.g., 10:1 and higher). Thus, the present invention presents a planarization process that is much more flexible (and thus more reliable) than prior art processes that rely on both a 1:1 etch rate ratio between metal and a planarizing resin and a pre-planarized passivation surface. In the invention, an Al₂O₃/water/oxidizing agent slurry having a pH above approximately 7.5 will provide a planarized tungsten-BPSG surface.

Thus, a planarized metal-insulator surface is formed after metal is deposited in vias having equal depth. Via-filling metallization technologies can be used to provide a planarized surface without producing overetched via holes. The resulting planarized surface yields a host of advantages. Because the metal above the filled vias is totally removed, undesired coupling between filled vias is eliminated. When a second metal layer is subsequently deposited on the planarized surface for interconnection, the photoresist layer used to pattern the layer will be deposited on a planar surface, enhancing the coverage of the photoresist. Moreover, after patterning the metal through this photoresist, the parasitic capacitance associated with the respective metal layers decreases, because the distance between the "plates" of the parasitic capacitors decreases due to enhanced planarity. The resistance of the metal lines will also decrease due to planarity. In general, the resulting planarized surface is more compatible with high density IC's in which multiple layers of metal are needed for inter-connection.

Although the invention has been shown and described with reference to forming conductive studs to a first layer of metal, it is compatible with any metal level. As shown in Fig. 7, the invention can be used to simultaneously form a metal line over the isolation region 10 and a contact to a diffusion region 14 of an FET device having another diffused region 12 and a gate electrode 16.

Moreover, while conformal metal layers such as tungsten are preferred, metal layers other than tungsten can be used. For example, assuming no hole-fill problems, conductive materials such as the above-mentioned aluminum-based alloys can be used to fill the vias. Aluminum and silicon oxide can be polished at approximately the same rate by using a Rodell 210 I2 polish pad at 13.79-55.16 KPa (2-8 psi) in the presence of a slurry consisting of aluminum particulates and deionized water (one gram/liter).

## Claims

1. A method of forming a plurality of conductive studs within an insulator layer (40) disposed between a first series of conductive structures (30) arranged on a substrate (1) and a second series of conductive structures formed on an upper surface of the insulator layer, comprising the steps of:
forming the insulator layer on the substrate, the insulator layer having a non-planar upper surface which follows the topology produced by the underlying layers;
defining vias (45) through said non-planar upper surface of said insulator layer, so as to expose at least one of said plurality of first conductive structures (30) disposed on the substrate;
depositing a conformal conductive layer on said non-planar upper surface of said insulator layer, said conductive layer completely filling said vias to contact said at least one of said plurality of first conductive structures, said conductive layer having a non-planar upper surface that substantially follows the topology of said non-planar upper surface of said insulating layer; and then
subjecting both of said non-planar upper surface of said conductive layer and said non-planar upper surface of said insulator layer to a single polish etch being the first planarization etch of this method, in the presence of an abrasive slurry, so as to remove portions of said conductive layer lying outside of said vias in said insulator layer, so as to eliminate undesired coupling between filled vias, while simultaneously removing portions of said insulator layer having said non-planar upper surface, so as to establish planarity in said upper surface of said insulator layer.

2. The method of Claim 1, wherein said conductive layer comprises a conformal metal.

3. The method as recited in Claim 2, wherein said conformal metal comprises chemical vapor deposited tungsten.

4. The method as recited in Claim 3, wherein said insulator layer is comprised of a doped glass.

5. The method as recited in Claim 4, wherein said abrasive slurry is comprised of alumina particulates, deionized water, a base, and an oxidizing agent which is different from the base.

6. The method as recited in Claim 5, wherein said oxidizing agent comprises hydrogen peroxide.

7. The method as recited in Claim 6, wherein said slurry has a pH above approximately 7.5.

8. The method as recited in Claim 1, wherein said conductive layer is comprised of an aluminum-based alloy, and wherein said insulator layer is comprised of doped glass.

9. The method as recited in Claim 8, wherein said slurry is comprised of alumina particulates and deionized water.

10. A method of forming a plurality of conductive studs within a doped glass layer disposed between a first series of conductive structures arranged on a substrate and a second series of conductive structures formed on an upper surface of the passivation layer, comprising the steps of:
depositing the doped glass layer on the substrate, the doped glass layer having a non-planar upper surface, which follows the topology produced by the underlying layers;
defining vias through said non-planar upper surface of the doped glass layer, so as to expose one or more of said plurality of first conductive structures on said substrate, said vias having substantially vertical sidewalls;
depositing a conformal metal layer on said non-planar upper surface of the doped glass layer, said conformal metal layer filling said vias in the doped glass layer, said conformal metal layer having a non-planar upper surface that substantially follows the topology of said non-planar upper surface of the doped glass layer; and then
subjecting both of said non-planar upper surface of said conformal metal layer and said non-planar upper surface of the doped glass layer to a single polish etch step being the first planarization etch step of this method, in the presence of a basic abrasive slurry, so as to remove portions of the conformal metal layer outside of said vias in the doped glass layer, so as to eliminate undesired coupling between filled vias, while simultaneously removing portions of said insulator layer having said non-planar upper surface, so as to establish planarity in said upper surface of the doped glass layer.

## Patentansprüche

1. Verfahren zur Ausbildung einer Vielzahl leitender Zapfen in einer Isolierschicht (40), die zwischen einer ersten Reihe auf einem Substrat (1) angeordneter leitender Strukturen (30) und einer zweiten Reihe auf der oberen Fläche der Isolierschicht befindlicher leitender Strukturen aufgebracht wird, wobei das Verfahren folgende Schritte umfaßt:
Aufbringen der Isolierschicht auf das Substrat, wobei die Isolierschicht eine unebene obere Fläche aufweist, die der von den unterliegenden Schichten bestimmten Oberflächengestalt angepaßt ist;
Bilden von Durchgangsöffnungen (45) durch die unebene obere Fläche der Isolierschicht, um mindestens eine der ersten auf dem Substrat befindlichen leitenden Strukturen (30) freizulegen;
Aufbringen einer konformen, leitenden Schicht auf der unebenen oberen Fläche der Isolierschicht, wobei die leitende Schicht die Durchgangsöffnungen vollständig füllt und dabei mindestens eine der ersten leitenden Strukturen berührt, wobei die leitende Schicht eine unebene obere Fläche aufweist, die weitgehend der Oberflächengestalt der unebenen oberen Fläche der Isolierschicht angepaßt ist; und daraufhin
Aussetzen sowohl der unebenen oberen Fläche der leitenden Schicht als auch der unebenen oberen Fläche der Isolierschicht in Anwesenheit eines abschleifenden Schlamms einem einzigen Polierungsätzvorgang, welcher das erste Einebnungsätzen dieses Verfahrens darstellt, um Teile der leitenden Schicht zu entfernen, die außerhalb der Durchgangsöffnungen in der Isolierschicht liegen, und damit eine unerwünschte Kopplung zwischen gefüllten Durchgangsöffnungen zu beseitigen, und gleichzeitig Teile der Isolierschicht mit unebener oberer Fläche zu entfernen, wodurch die Ebenheit der oberen Flache der Isolierschicht hergestellt wird.

2. Verfahren nach Anspruch 1, bei dem die leitende Schicht ein sich an die Oberflächenform anpassendes Metall umfaßt.

3. Verfahren nach Anspruch 2, bei dem das sich an die Oberflächenform anpassende Metall chemisch abgeschiedenes Wolfram umfaßt.

4. Verfahren nach Anspruch 3, bei dem die Isolierschicht ein dotiertes Glas umfaßt.

5. Verfahren nach Anspruch 4, bei dem der abschleifende Schlamm Aluminiumoxidpartikeln, entionisiertes Wasser, eine Base und ein von der Base verschiedenes Oxidationsmittel umfaßt.

6. Verfahren nach Anspruch 5, bei dem das Oxidationsmittel Wasserstoffperoxid umfaßt.

7. Verfahren nach Anspruch 6, bei dem der Schlamm einen pH-Wert über etwa 7,5 besitzt.

8. Verfahren nach Anspruch 1, bei dem die leitende Schicht eine Legierung auf Aluminium-Basis und die Isolierschicht ein dotiertes Glas umfassen.

9. Verfahren nach Anspruch 8, bei dem der Schlamm Aluminiumoxidpartikeln und entionisiertes Wasser enthält.

10. Verfahren zur Ausbildung einer Vielzahl leitender Zapfen in einer dotierten Glasschicht, die zwischen einer ersten Reihe auf einem Substrat angeordneter leitender Strukturen und einer zweiten Reihe auf einer oberen Fläche der Passivierungsschicht gebildeter leitender Strukturen aufgebracht wird, wobei das Verfahren folgende Schritte umfaßt:
Aufbringen der dotierten Glasschicht auf das Substrat, wobei die dotierte Glasschicht eine unebene obere Fläche aufweist, die der von den unterliegenden Schichten bestimmten Oberflächengestalt angepaßt ist;
Bilden von Durchgangsöffnungen durch die unebene obere Fläche der dotierten Glasschicht, um eine oder mehrere der ersten, auf dem Substrat befindlichen leitenden Strukturen freizulegen, wobei die Durchgangsöffnungen weitgehend senkrechte Seitenwände aufweisen;
Aufbringen einer sich an die Oberflächenform anpassenden Metallschicht auf der unebenen oberen Fläche der dotierten Glasschicht, wobei die sich an die Oberflächenform anpassende Metallschicht die Durchgangsöffnungen in der dotierten Glasschicht vollständig füllt und eine unebene obere Fläche aufweist, die weitgehend der Oberflächengestalt der unebenen oberen Fläche der dotierten Glasschicht angepaßt ist; und daraufhin
Aussetzen sowohl der unebenen oberen Fläche der konformen Metallschicht als auch der unebenen oberen Fläche der dotierten Glasschicht in Anwesenheit eines basischen abschleifenden Schlamms einem einzigen Polierätzvorgang, welcher den ersten Einebnungsätzvorgang dieses Verfahrens darstellt, um Teile der konformen Metallschicht zu entfernen, die in der dotierten Glasschicht außerhalb der Durchgangsverbindungen liegen, und damit eine unerwünschte Kopplung zwischen gefüllten Durchgangsverbindungen zu beseitigen, und gleichzeitig Teile der Isolierschicht mit unebener oberer Fläche zu entfernen, wodurch die Ebenheit der oberen Fläche der dotierten Glasschicht hergestellt wird.

## Revendications

1. Procédé pour former un grand nombre de piliers conducteurs à l'intérieur d'une couche isolante (40) disposée entre une première série de structures conductrices (30) arrangées sur un substrat (1) et une seconde série de structures conductrices formées sur une surface supérieure de la couche isolante, comprenant les étapes de :
formation de la couche isolante sur le substrat, la couche isolante ayant une surface supérieure non planaire qui suit la topologie produite par les couches sous-jacentes;
définition de trous de passage (45) à travers cette surface supérieure non planaire de cette couche isolante, de façon à exposer au moins l'une de ces nombreuses premières structures conductrices (30) disposées sur le substrat;
dépôt d'une couche conductrice épousant les formes sur cette surface supérieure non planaire de cette couche isolante, cette couche conductrice remplissant complètement ces trous de passage pour entrer en contact avec au moins l'une de ces nombreuses premières structures conductrices, cette couche conductrice ayant une surface supérieure non planaire qui suit pratiquement la topologie de cette surface supérieure non planaire de cette couche isolante, et ensuite,
soumission de cette surface supérieure non planaire de cette couche conductrice et de cette couche supérieure non planaire de cette couche isolante à une unique attaque par polissage, constituant la première attaque de planarisation de ce procédé, en présence d'une bouillie abrasive, de façon à éliminer les parties de cette couche conductrice se trouvant à l'extérieur de ces trous de passage dans cette couche isolante afin d'éliminer tout couplage indésiré entre les trous de passage remplis, tout en supprimant simultanément les parties de cette couche isolante ayant une surface supérieure non planaire, de façon à établir une planarité dans cette surface supérieure de cette couche isolante.

2. Procédé suivant la revendication 1, dans lequel cette couche conductrice comprend un métal épousant les formes.

3. Procédé suivant la revendication 2, dans lequel ce métal épousant les formes comprend du tungstène déposé à partir d'une vapeur chimique.

4. Procédé suivant la revendication 3, dans lequel cette couche isolante est composée d'un verre dopé.

5. Procédé suivant la revendication 4, dans lequel cette bouillie abrasive est composée d'alumine particulaire, d'eau désionisée, d'une base et d'un agent oxydant qui est différent de la base.

6. Procédé suivant la revendication 5, dans lequel cet agent oxydant comprend le peroxyde d'hydrogène.

7. Procédé suivant la revendication 6, dans lequel cette bouilie a un pH supérieur à environ 7,5.

8. Procédé suivant la revendication 1, dans lequel cette couche conductrice est composée d'un alliage à base d'aluminium et cette couche isolante est composée de verre dopé.

9. Procédé suivant la revendication 8, dans lequel cette bouillie est composée d'alumine particulaire et d'eau désionisée.

10. Procédé pour former un grand nombre de piliers conducteurs à l'intérieur d'une couche isolante disposée entre une première série de structures conductrices arrangées sur un substrat et une seconde série de structures conductrices formées sur une surface supérieure de la couche de passivation, comprenant les étapes de :
dépôt de la couche de verre dopé sur le substrat, la couche de verre dopé ayant une surface supérieure non planaire qui suit la topologie produite par les couches sous-jacentes;
définition de trous de passage à travers cette surface supérieure non planaire de la couche de verre dopé, de façon à exposer au moins l'une ou plusieurs de ces nombreuses premières structures conductrices sur ce substrat, ces trous de passage ayant des parois latérales pratiquement verticales;
dépôt d'une couche de métal épousant les formes sur cette surface supérieure non planaire de cette couche de verre dopé, cette couche de métal époussant les formes remplissant ces trous de passage dans la couche de verre dopé, cette couche de métal épousant les formes ayant une surface supérieure non planaire qui suit pratiquement la topologie de cette surface supérieure non planaire de la couche de verre dopé, et ensuite,
soumission de cette surface supérieure non planaire de cette couche métallique épousant les formes et de cette couche supérieure non planaire de cette couche de verre dopé à une unique attaque par polissage, constituant la première attaque de planarisation de ce procédé, en présence d'une bouillie abrasive basique de façon à éliminer les parties de cette couche métallique épousant les formes à l'extérieur de ces trous de passage dans cette couche de verre dopé afin d'éliminer tout couplage indésiré entre des trous de passage remplis, tout en supprimant simultanément les parties de cette couche isolante ayant cette surface supérieure non planaire, de façon à établir une planarité dans cette surface supérieure de la couche de verre dopé.
